# EUROPEAN PATENT SPECIFICATION

(11) **EP 4 446 760 B1**
(45) Date of publication and mention of the grant of the patent: **10.12.2025**
(21) Application number: 22920839.2
(22) Date of filing: 29.12.2022
(51) Int. Cl.: G01R 31/389, G01R 27/08, G01R 31/36, G01R 31/3842, G01R 19/165, G01R 31/3835

(54) **BATTERY DEPTH-OF-CHARGE CALCULATION APPARATUS AND OPERATING METHOD THEREOF**
VORRICHTUNG ZUR BERECHNUNG DER LADETIEFE EINER BATTERIE UND BETRIEBSVERFAHREN DAFÜR
APPAREIL DE CALCUL DE PROFONDEUR DE CHARGE DE BATTERIE ET PROCÉDÉ DE FONCTIONNEMENT ASSOCIÉ

(30) Priority: 11.01.2022 KR 20220004355
(43) Date of publication of application: 16.10.2024
(73) Proprietor: LG Energy Solution, Ltd., Seoul 07335 (KR)
(72) Inventor: YU, Jeong In, Daejeon 34122 (KR); YOON, Yeo Kyung, Daejeon 34122 (KR); KIM, Yong Jun, Daejeon 34122 (KR)
(74) Representative: Plasseraud IP
(86) International application number: PCT/KR2022/021563
(87) International publication number: WO 2023/136512

(56) References cited:
- EP-A1- 2 952 922
- JP-A- 2020 169 968
- KR-A- 20170 006 400
- KR-A- 20170 086 876
- KR-A- 20210 141 219
- US-A1- 2005 242 777
- US-A1- 2007 166 607
- US-B2- 11 193 985

## Description

### [TECHNICAL FIELD]

### CROSS-REFERENCE TO RELATED APPLICATION

This application claims priority to and the benefit of Korean Patent Application No. 10-2022-0004355 filed in the Korean Intellectual Property Office on January 11, 2022.

### TECHNICAL FIELD

Embodiments disclosed herein relate to a battery depth-of-charge calculation apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Recent batteries have a fast charging function. Fast charge may be related to the fast charge life of the battery depending on a configuration scheme of a charge protocol. Thus, a method for configuring a charge protocol is required, and there is a method of manufacturing three electrodes of a monocell type to identify a depth of charging and deriving a charge protocol for a large cell based on the identified depth of charging of the monocell type.

According to an existing depth-of-charge check method, an inflection point is checked through a differential curve based on a charge profile, but different values may be read depending on an individual's gaze. Moreover, even when a negative electrode profile is derived from three electrodes, a possibility of change exists depending on time, resulting in the inconvenience of having to manufacturing a reference battery cell together.

US 2007/166607 A1 discloses a battery arrangement wherein the inner resistance is detected and a correlation between depth of charge and inner resistance is disclosed.

### [DISCLOSURE]

### [TECHNICAL PROBLEM]

Embodiments disclosed herein aim to provide a battery depth-of-charge calculation apparatus and an operating method thereof in which an inner resistance value of a battery cell may be calculated and a depth-of-charge of the battery cell may be calculated based on the calculated inner resistance value.

Embodiments disclosed herein aim to provide a battery depth-of-charge calculation apparatus and an operating method thereof in which a depth-of-charge of a battery cell may be calculated based on an inner resistance value of a dual electrode full cell without manufacturing three electrodes of the battery cell.

Technical problems of the embodiments disclosed herein are not limited to the above-described technical problems, and other unmentioned technical problems would be clearly understood by one of ordinary skill in the art from the following description.

### [TECHNICAL SOLUTION]

A battery depth-of-charge calculation apparatus according to an embodiment disclosed herein includes an information obtaining unit configured to obtain an open circuit voltage (OCV) value with respect to a state of charge (SoC) of a battery cell and information about a voltage value with respect to an SoC of the battery cell during charge, a resistance calculating unit configured to calculate an inner resistance value with respect to the SoC of the battery cell during charge, based on the information about the voltage value with respect to the SoC of the battery cell during charge and the open circuit voltage value with respect to the SoC of the battery cell, and a depth-of-charge calculating unit configured to calculate a negative electrode depth-of-charge of the battery cell based on the inner resistance value.

In an embodiment, the depth-of-charge calculating unit may be further configured to calculate a negative electrode depth-of-charge of the battery cell by comparing the inner resistance value with a preset value.

In an embodiment, the preset value may be 2 ohms.

In an embodiment, the resistance calculating unit may be further configured to calculate the over-voltage value with respect to the SoC of the battery cell, which is a difference between the voltage value with respect to the SoC of the battery cell and the open circuit voltage value with respect to the SoC of the battery cell and calculate the internal resistance value of the battery cell during charge by dividing the calculated over-voltage value with respect to the SoC of the battery cell by a current value flowing through the battery cell.

In an embodiment, the resistance calculating unit may be further configured to calculate the internal resistance value with respect to the SoC of the battery cell during charge for each C-rate for charging the battery cell.

In an embodiment, the depth-of-charge calculating unit may be further configured to calculate a negative electrode depth-of-charge of the battery cell for each C-rate.

In an embodiment, a negative electrode depth-of-charge of the battery cell may be used to generate a charge protocol of the battery cell.

In an embodiment, the depth-of-charge may be an SoC in which precipitation of ions included in the battery cell occurs.

An operating method of a battery depth-of-charge calculation apparatus according to an embodiment disclosed herein may include obtaining an open circuit voltage (OCV) value with respect to a state of charge (SoC) of a battery cell and information about a voltage value with respect to an SoC of the battery cell during charge, calculating an inner resistance value with respect to the SoC of the battery cell during charge, based on the information about the voltage value with respect to the SoC of the battery cell during charge and the open circuit voltage value with respect to the SoC of the battery cell, and calculating a negative electrode depth-of-charge of the battery cell based on the inner resistance value.

In an embodiment, the calculating of the negative electrode depth-of-charge of the battery cell based on the inner resistance value may include calculating a negative electrode depth-of-charge of the battery cell by comparing the inner resistance value with a preset value.

In an embodiment, the calculating of the inner resistance value with respect to the SoC of the battery cell during charge, based on the information about the voltage value with respect to the SoC of the battery cell during charge and the open circuit voltage value with respect to the SoC of the battery cell may include calculating the over-voltage value with respect to the SoC of the battery cell, which is a difference between a voltage value with respect to the SoC of the battery cell and the open circuit voltage value with respect to the SoC of the battery cell and calculating the internal resistance value of the battery cell during charge by dividing the calculated over-voltage value with respect to the SoC of the battery cell by a current value flowing through the battery cell.

### [ADVANTAGEOUS EFFECTS]

A battery depth-of-charge calculation apparatus and an operating method thereof according to an embodiment disclosed herein may calculate an inner resistance value of a battery cell for each C-rate and calculate a depth-of-charge of the battery cell based on the calculated inner resistance value.

A battery depth-of-charge calculation apparatus and an operating method thereof according to an embodiment disclosed herein may calculate a depth of charge based on an inner resistance value by using a change of the inner resistance value as a guide of the depth of charge because the change of the inner resistance value is analyzed as originating from a negative electrode.

In a battery depth-of-charge calculation apparatus and an operating method thereof according to an embodiment disclosed herein, a large cell may autonomously calculate a depth of charge without manufacturing three electrodes of a monocell type.

Moreover, various effects recognized directly or indirectly from the disclosure may be provided.

### [DESCRIPTION OF DRAWINGS]

FIG. 1 is a block diagram of a general battery pack.
FIG. 2 is a block diagram of a battery depth-of-charge calculation apparatus according to an embodiment disclosed herein.
FIG. 3 shows an inner resistance value of a battery cell with respect to a C-rate, according to an embodiment disclosed herein.
FIG. 4 shows an example in which a battery depth-of charge calculation apparatus according to an embodiment disclosed herein calculates a depth of charge.
FIG. 5 is a flowchart showing an operating method of a battery depth-of-charge calculation apparatus according to an embodiment disclosed herein.
FIG. 6 is a flowchart showing in detail an operating method of a battery depth-of-charge calculation apparatus according to an embodiment disclosed herein.
FIG. 7 is a block diagram showing a hardware configuration of a computing system for performing an operating method of a battery depth-of-charge calculation apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

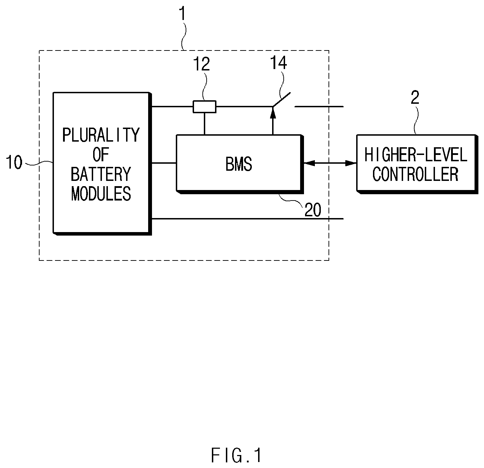

FIG. 1 is a block diagram of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a battery module 10 that includes one or more battery cells and is chargeable/dischargeable, a switching unit 14 serially connected to a positive (+) terminal side or a negative (-) terminal side of the battery module 10 to control a charging/discharging current flow of the battery module 10, and a battery management system (e.g., RBMS) 20 for control and management to prevent over-charging and over-discharging by monitoring a voltage, a current, a temperature, etc., of the battery pack 1. The battery pack 1 may include the battery module 10, the sensor 12, the switching unit 14, and the battery management system 20 provided in plural.

Herein, as the switching unit 14 which is an element for controlling a current flow for charging or discharging of the plurality of battery modules 10, for example, at least one relay, magnetic contactor, etc., may be used according to specifications of the battery pack 1.

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the battery module 10 to monitor the state of each battery module 10.

Meanwhile, the battery management system 20 according to the present invention may perform regression analysis on a voltage of a battery cell through a separate program, as will be described below. An abnormal type of the battery cell may be classified using a calculated regression equation.

The higher-level controller 2 may transmit a control signal regarding the battery module 10 to the battery management system 20. Thus, the battery management system 20 may also be controlled in terms of an operation thereof based on a signal applied from the higher-level controller 2.

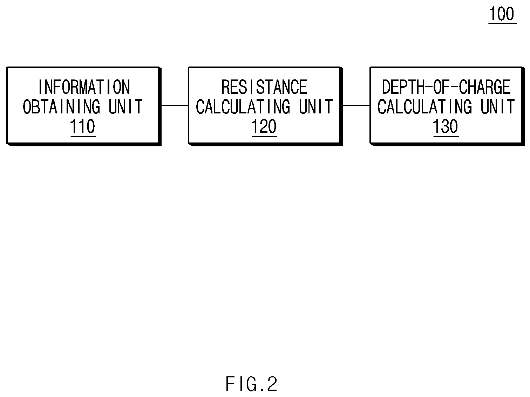

FIG. 2 is a block diagram of a battery depth-of-charge calculation apparatus according to an embodiment disclosed herein.

Referring to FIG. 2, a battery depth-of-charge calculation apparatus 100 according to an embodiment disclosed herein may include an information obtaining unit 110, a resistance calculating unit 120, and a depth-of-charge calculating unit 130. In an embodiment, the information obtaining unit 110, the resistance calculating unit 120, and the depth-of-charge calculating unit 130 may be implemented as one module. In an embodiment, the information obtaining unit 110, the resistance calculating unit 120, and the depth-of-charge calculating unit 130 may be included in a controller (e.g., a processor, an MCU, an ECU). In an embodiment, the battery depth-of-charge calculation apparatus 100 may be included in the BMS 20 shown in FIG. 1. However, without being limited thereto, according to an embodiment, the battery depth-of-charge calculation apparatus 100 may be included in another device (e.g., a computer, etc.) instead of being included in a battery pack (e.g., the battery pack 1 of FIG. 1).

The information obtaining unit 110 may obtain an open circuit voltage (OCV) value with respect to a state of charge (SoC) of the battery cell. For example, the information obtaining unit 110 may obtain an OCV value for each SoC.

The information obtaining unit 110 may obtain information about a voltage value with respect to an SoC of the battery cell during charge. For example, the information obtaining unit 110 may obtain information about a voltage value with respect to an SoC of the battery cell during charge for each charge C-rate. According to an embodiment, a voltage value with respect to an SoC of the battery cell during charge may be directly measured by the information obtaining unit 110 or may be obtained from another measuring apparatus that measures voltage and current of the battery cell.

According to an embodiment, the information obtaining unit 110 may transmit the obtained information to the resistance calculating unit 120 or the depth-of-charge calculating unit 130.

The resistance calculating unit 120 may calculate the inner resistance value with respect to the SoC of the battery cell during charge, based on information about a voltage value with respect to the SoC of the battery cell and an open circuit voltage value (OCV value) with respect to the SoC of the battery cell. For example, the resistance calculating unit 120 may calculate an over-voltage value with respect to the SoC of the battery cell, which is a difference between a voltage value with respect to the SoC of the battery cell and the open circuit voltage value with respect to the SoC of the battery cell. In this case, the resistance calculating unit 120 may calculate an over-voltage value for each SoC of the battery cell.

The resistance calculating unit 120 may calculate the inner resistance value with respect to the SoC of the battery cell during charge, by dividing the calculated over-voltage value with respect to the SoC of the battery cell by a current value flowing through the battery cell. For example, the resistance calculating unit 120 may calculate the inner resistance value of the battery cell during charge for each SoC of the battery cell. In another example, the current value flowing through the battery cell may be obtained from the information obtaining unit 110 and from a battery pack including the battery cell.

According to an embodiment, the resistance calculating unit 120 may calculate the inner resistance value of the battery cell during charge for each C-rate for charging the battery cell. For example, the resistance calculating unit 120 may calculate the inner resistance value of the battery cell during charge for each SoC with respect to each C-rate.

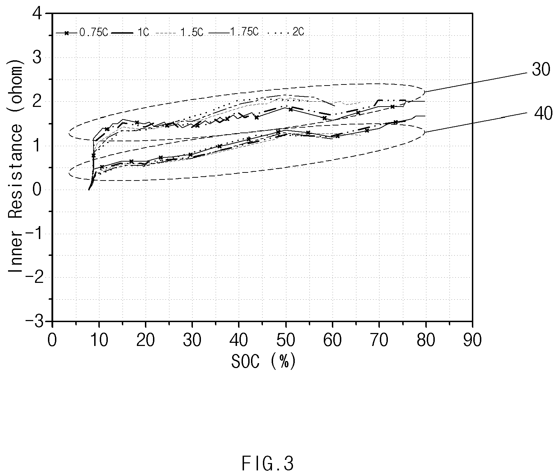

The depth-of-charge calculating unit 130 may calculate the depth of charge of the battery cell based on the inner resistance value. For example, the depth-of-charge calculating unit 130 may calculate a negative electrode depth-of-charge of the battery cell based on the inner resistance value calculated by the resistance calculating unit 120. According to an embodiment, as will be described with reference to FIG. 3, graphs of an inner resistance value of the entire battery cell and an inner resistance value of a negative terminal of the battery cell are similar in shape, such that the depth-of-charge calculating unit 130 may calculate a negative electrode depth-of-charge of the battery cell based on an inner resistance value.

The depth-of-charge calculating unit 130 may compare an inner resistance value with a preset value. For example, the depth-of-charge calculating unit 130 may calculate the negative electrode depth-of-charge of the battery cell by comparing the inner resistance value with the preset value. According to an embodiment, the preset value may be 2 ohms. According to an embodiment, the depth-of-charge calculating unit 130 may calculate, as the negative electrode depth-of-charge, an SoC of a battery cell with an inner resistance value reaching the preset value.

According to an embodiment, the depth-of-charge calculating unit 130 may calculate the negative electrode depth-of-charge of the battery cell for each C-rate for charging the battery cell. For example, the negative electrode depth-of-charge of the battery cell may decrease for higher C-rates and increase for lower C-rates. In another example, as a C-rate increases, precipitation of ions included in a negative electrode of a battery cell is accelerated, such that a depth of charge may decrease.

In an embodiment, the negative electrode depth-of-charge of the battery cell, calculated by the depth-of-charge calculating unit 130, may be used to generate a charge protocol of the battery cell. For example, based on a negative electrode depth-of-charge calculated for a C-rate, a charge protocol may be set to perform charge up to the depth of charge for the C-rate.

In an embodiment, the depth of charge may correspond to a timepoint at which precipitation of the ions included in the battery cell occurs. For example, the depth of charge may correspond to a timepoint at which precipitation of ions included in a negative electrode occurs. When precipitation of ions occur, charge should not progress any more for the C-rate, such that it may be important to determine a fast charge protocol by calculating the depth of charge.

A battery depth-of-charge calculation apparatus according to an embodiment disclosed herein may calculate an inner resistance value of a battery cell for each C-rate and calculate a depth-of-charge of the battery cell based on the calculated inner resistance value.

A battery depth-of-charge calculation apparatus according to an embodiment disclosed herein may calculate a depth of charge based on an inner resistance value by using a change of the inner resistance value as a guide of the depth of charge because the change of the inner resistance value is analyzed as originating from a negative electrode.

In a battery depth-of-charge calculation apparatus according to an embodiment disclosed herein, a large cell may autonomously calculate a depth of charge without manufacturing three electrodes of a monocell type.

FIG. 3 shows an inner resistance value of a battery cell with respect to a C-rate, according to an embodiment disclosed herein.

Referring to FIG. 3, it may be seen that an inner resistance value 30 of the entire battery cell with respect to a charge C-rate changes with an SoC.

It may be seen that an inner resistance value 40 of a negative electrode of the battery cell with respect to a charge C-rate changes with an SoC.

The inner resistance value 30 of the entire battery cell with respect to the charge C-rate and the inner resistance value 40 of the negative electrode of the battery cell with respect to the charge C-rate have similar graph shapes. That is, a change in the inner resistance value of the entire battery cell may be determined as a change with respect to a change in the inner resistance value of the negative electrode of the battery cell.

Thus, the battery depth-of-charge calculation apparatus 100 according to an embodiment may predict the inner resistance value of the negative electrode of the battery cell based on the inner resistance value 30 of the entire battery cell without separately calculating the inner resistance value 40 of the negative electrode of the battery cell.

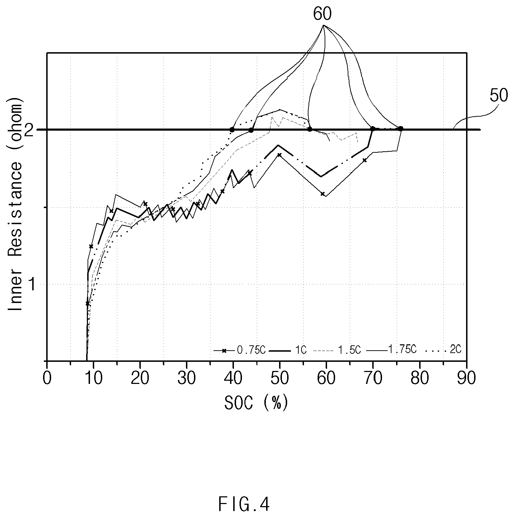

FIG. 4 shows an example in which a battery depth-of charge calculation apparatus according to an embodiment disclosed herein calculates a depth of charge.

Referring to FIG. 4, the battery depth-of-charge calculation apparatus (the battery depth-of charge calculation apparatus 100 of FIG. 2) may calculate an inner resistance value of a battery cell. For example, the battery depth-of-charge calculation apparatus 100 may calculate the inner resistance value of the battery cell for each SoC of the battery cell. In addition, the battery depth-of-charge calculation apparatus 100 may calculate the inner resistance value of the battery cell for each charge C-rate.

The battery depth-of-charge calculation apparatus 100 may compare the calculated inner resistance value of the battery cell with a preset value 50. For example, the preset value may be 2 ohms in FIG. 4.

The battery depth-of-charge calculation apparatus 100 may calculate an SoC of a battery cell with an inner resistance value corresponding to the preset value 50 as a negative electrode depth-of-charge 60 of the battery cell for a corresponding C-rate. For example, for a C-rate of 2C, the battery depth-of-charge calculation apparatus 100 may calculate the negative electrode depth-of-charge of the battery cell as an SoC of 40. In another example, for a C-rate of 1C, the battery depth-of-charge calculation apparatus 100 may set the negative electrode depth-of-charge of the battery cell to an SoC of 70.

The battery depth-of-charge calculation apparatus 100 may use the calculated negative electrode depth-of-charge of the battery cell to set a charge protocol. For example, based on the negative electrode depth-of-charge of the battery cell, calculated by the battery depth-of-charge calculation apparatus 100, the user may set the charge protocol to charge the battery cell up to an SoC of 40 at a 2 C-rate, up to an SoC of 45 at a 1.75 C-rate, and up to an SoC of 55 at a 1.5 C-rate. While five examples of a C-rate are shown in FIG. 4, the battery depth-of-charge calculation apparatus 100 may calculate a depth-of-charge of a battery cell corresponding to various C-rates, without being limited thereto. Thus, a charge profile may be set in more detail based on a negative electrode depth-of-charge of a battery cell.

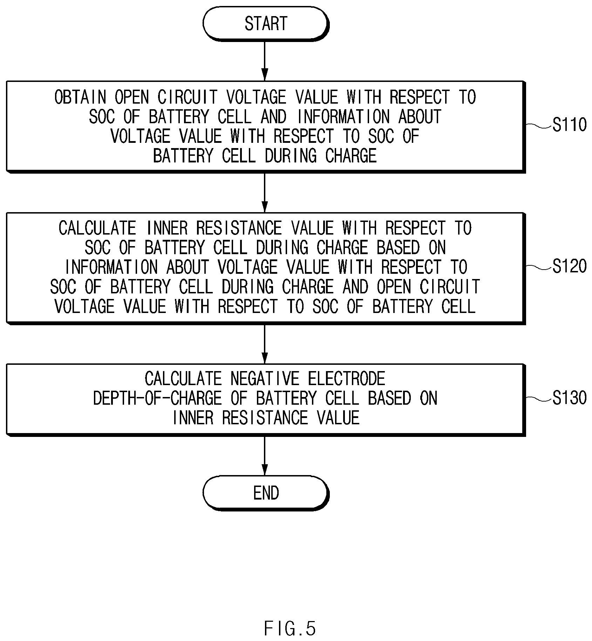

FIG. 5 is a flowchart showing an operating method of a battery depth-of-charge calculation apparatus according to an embodiment disclosed herein.

Referring to FIG. 5, an operating method of the battery depth-of-charge calculation apparatus 100 according to an embodiment disclosed herein may include operation S110 of obtaining an open circuit voltage value with respect to an SoC of a battery cell and information about a voltage value with respect to an SoC of the battery cell during charge, operation S120 of calculating an inner resistance value with respect to the SoC of the battery cell during charge based on the information about the voltage value with respect to the SoC of the battery cell during charge and the open circuit voltage value with respect to the SoC of the battery cell, and operation S130 of calculating a depth-of-charge of the battery cell based on the inner resistance value.

In operation S110 of obtaining the open circuit voltage value with respect to the SoC of the battery cell and the information about the voltage value with respect to the SoC of the battery cell during charge, the information obtaining unit 110 may obtain an OCV value with respect to the SoC of the battery cell. For example, the information obtaining unit 110 may obtain an OCV value for each SoC.

In operation S110, the information obtaining unit 110 may obtain the information about the voltage value with respect to the SoC of the battery cell during charge. For example, the information obtaining unit 110 may obtain information about a voltage value with respect to an SoC of the battery cell during charge for each charge C-rate. According to an embodiment, a voltage with respect to an SoC of the battery cell during charge may be directly measured by the information obtaining unit 110 or may be obtained from another measuring apparatus that measures voltage and current of the battery cell.

In operation S120 of calculating the inner resistance value with respect to the SoC of the battery cell during charge based on the information about the voltage value with respect to the SoC of the battery cell during charge and the open circuit voltage value with respect to the SoC of the battery cell, the resistance calculating unit 120 may calculate the inner resistance value of the battery cell during charge. For example, the resistance calculating unit 120 may calculate the inner resistance value with respect to the SoC of the battery cell during charge, based on the information about the voltage value with respect to the SoC of the battery cell during charge and the open circuit voltage value with respect to the SoC of the battery cell.

In operation S130 of calculating the depth-of-charge of the battery cell based on the inner resistance value, the depth-of-charge calculating unit 130 may calculate the negative electrode depth-of-charge of the battery cell based on the calculated inner resistance value. For example, the depth-of-charge calculating unit 130 may calculate the negative electrode depth-of-charge of the battery cell by comparing the inner resistance value with the preset value. The battery depth-of-charge calculation apparatus 100 may use the calculated negative electrode depth-of-charge of the battery cell to set a charge protocol.

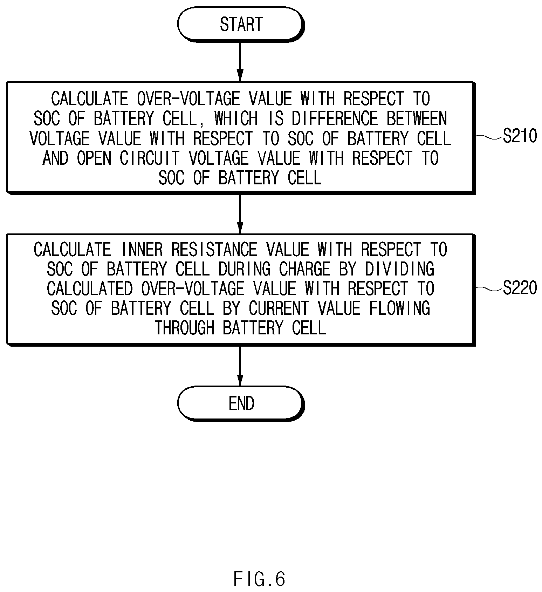

FIG. 6 is a flowchart showing in detail an operating method of a battery depth-of-charge calculation apparatus according to an embodiment disclosed herein.

Referring to FIG. 6, an operating method of the battery depth-of-charge calculation apparatus 100 according to an embodiment disclosed herein may include operation S210 of calculating an over-voltage value with respect to an SoC of the battery cell, which is a difference between a voltage value with respect to the SoC of the battery cell and an open circuit voltage value with respect to the SoC of the battery cell, and operation S220 of calculating the inner resistance value with respect to the SoC of the battery cell during charge by dividing the calculated over-voltage value with respect to the SoC of the battery cell by a current value flowing through the battery cell. According to an embodiment, operations S210 and S220 may be included in operation S120 of FIG. 5.

In operation S210 of calculating the over-voltage value with respect to the SoC of the battery cell, which is the difference between the voltage value with respect to the SoC of the battery cell and the open circuit voltage value with respect to the SoC of the battery cell, the resistance calculating unit 120 may calculate the inner resistance value with respect to the SoC of the battery cell during charge, based on information about the voltage value with respect to the SoC of the battery cell and the open circuit voltage value (OCV value) with respect to the SoC of the battery cell. For example, the resistance calculating unit 120 may calculate an over-voltage value with respect to the SoC of the battery cell, which is a difference between a voltage value with respect to the SoC of the battery cell and the open circuit voltage value with respect to the SoC of the battery cell. In this case, the resistance calculating unit 120 may calculate an over-voltage for each SoC of the battery cell.

In operation S220 of calculating the inner resistance value with respect to the SoC of the battery cell during charge by dividing the calculated over-voltage value with respect to the SoC of the battery cell by a current value flowing through the battery cell, the resistance calculating unit 120 may calculate the inner resistance value with respect to the SoC of the battery cell during charge by dividing the calculated over-voltage value with respect to the SoC of the battery cell by the current value flowing through the battery cell. For example, the resistance calculating unit 120 may calculate the inner resistance value of the battery cell during charge for each SoC of the battery cell. In another example, the current value flowing through the battery cell may be obtained from the information obtaining unit 110 and from a battery pack including the battery cell.

According to an embodiment, the resistance calculating unit 120 may calculate the inner resistance value of the battery cell during charge for each C-rate for charging the battery cell. For example, the resistance calculating unit 120 may calculate the inner resistance value of the battery cell during charge for each SoC with respect to each C-rate.

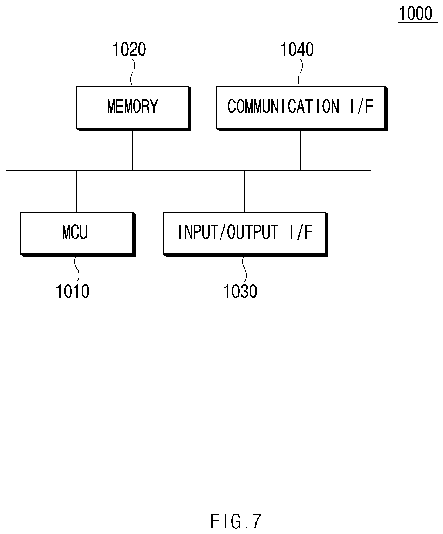

FIG. 7 is a block diagram showing a hardware configuration of a computing system for performing an operating method of a battery depth-of-charge calculation apparatus, according to an embodiment disclosed herein.

Referring to FIG. 7, a computing system 1000 according to an embodiment disclosed herein may include an MCU 1010, a memory 1020, an input/output I/F 1030, and a communication I/F 1040.

The MCU 1010 may be a processor that executes various programs (e.g., a battery pack voltage or current collection program, a relay control program included in a battery pack, an inner resistance calculation program, etc.) stored in the memory 1020, processes various information including the inner resistance value of the battery and comparison information between the inner resistance value of the battery and a preset value, and performs functions of the battery depth-of-charge calculation apparatus of FIG. 2 described above.

The memory 1020 may store various programs regarding log information collection and diagnosis of the battery, etc. The memory 1020 may also store various information such as a current, a voltage, an inner resistance value, an OCV value, charge protocol information, charge C-rate information, etc., of the battery.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery depth-of-charge calculation apparatus may transmit and receive a relay control program included in a battery pack or information such as a current, a voltage, or an inner resistance value of various battery packs from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

The above description is merely illustrative of the technical idea of the present disclosure, and various modifications and variations within the scope of the claims will be possible without departing from the essential characteristics of embodiments of the present disclosure by those of ordinary skill in the art to which the embodiments disclosed herein pertains.

## Claims

1. A battery depth-of-charge calculation apparatus (100) comprising:
an information obtaining unit (110) configured to obtain an open circuit voltage (OCV) value with respect to a state of charge (SoC) of a battery cell and information about a voltage value with respect to an SoC of the battery cell during charge;
a resistance calculating unit (120) configured to calculate an inner resistance value (30) with respect to the SoC of the battery cell during charge, based on the information about the voltage value with respect to the SoC of the battery cell during charge and the open circuit voltage value with respect to the SoC of the battery cell; and
a depth-of-charge calculating unit (130) configured to calculate a negative electrode depth-of-charge of the battery cell based on the inner resistance value (30).

2. The battery depth-of-charge calculation apparatus of claim 1, wherein the depth-of-charge calculating unit (130) is further configured to calculate a negative electrode depth-of-charge of the battery cell by comparing the inner resistance value (30) with a preset value.

3. The battery depth-of-charge calculation apparatus of claim 2, wherein the preset value is 2 ohms.

4. The battery depth-of-charge calculation apparatus of claim 1, wherein the resistance calculating unit (120) is further configured to:
calculate the over-voltage value with respect to the SoC of the battery cell, which is a difference between the voltage value with respect to the SoC of the battery cell and the open circuit voltage value with respect to the SoC of the battery cell; and
calculate the internal resistance value of the battery cell during charge by dividing the calculated over-voltage value with respect to the SoC of the battery cell by a current value flowing through the battery cell.

5. The battery depth-of-charge calculation apparatus of claim 1, wherein the resistance calculating unit (120) is further configured to calculate the internal resistance value with respect to the SoC of the battery cell during charge for each C-rate for charging the battery cell.

6. The battery depth-of-charge calculation apparatus of claim 5, wherein the depth-of-charge calculating unit (130) is further configured to calculate a negative electrode depth-of-charge of the battery cell for each C-rate.

7. The battery depth-of-charge calculation apparatus of claim 1, wherein a negative electrode depth-of-charge of the battery cell is used to generate a charge protocol of the battery cell.

8. The battery depth-of-charge calculation apparatus of claim 1, wherein the depth-of-charge is an SoC in which precipitation of ions included in the battery cell occurs.

9. An operating method of a battery depth-of-charge calculation apparatus, the operating method comprising:
obtaining (S110) an open circuit voltage (OCV) value with respect to a state of charge (SoC) of a battery cell and information about a voltage value with respect to an SoC of the battery cell during charge;
calculating (S120) an inner resistance value (30) with respect to the SoC of the battery cell during charge, based on the information about the voltage value with respect to the SoC of the battery cell during charge and the open circuit voltage value with respect to the SoC of the battery cell; and
calculating (S130) a negative electrode depth-of-charge of the battery cell based on the inner resistance value (30).

10. The operating method of claim 9, wherein the calculating (S130) of the negative electrode depth-of-charge of the battery cell based on the inner resistance value (30) comprises calculating a negative electrode depth-of-charge of the battery cell by comparing the inner resistance value (30) with a preset value.

11. The operating method of claim 9, wherein the calculating (S120) of the inner resistance value (30) with respect to the SoC of the battery cell during charge, based on the information about the voltage value with respect to the SoC of the battery cell during charge and the open circuit voltage value with respect to the SoC of the battery cell comprises:
calculating the over-voltage value with respect to the SoC of the battery cell, which is a difference between a voltage value with respect to the SoC of the battery cell and the open circuit voltage value with respect to the SoC of the battery cell; and
calculating the internal resistance value (30) of the battery cell during charge by dividing the calculated over-voltage value with respect to the SoC of the battery cell by a current value flowing through the battery cell.

## Patentansprüche

1. Batterietiefenladung-Berechnungsvorrichtung (100), umfassend:
eine Informationen-Erhalteeinheit (110), welche dazu eingerichtet ist, einen offenen Schaltungsspannung-(OCV)-Wert in Bezug auf einen Ladezustand (SoC) einer Batteriezelle und Informationen über einen Spannungswert in Bezug auf einen SoC der Batteriezelle während eines Ladens zu erhalten;
eine Widerstand-Berechnungseinheit (120), welche dazu eingerichtet ist, einen inneren Widerstandswert (30) in Bezug auf den SoC der Batteriezelle während eines Ladens zu berechnen, auf Grundlage der Informationen über den Spannungswert in Bezug auf den SoC der Batteriezelle während eines Ladens und des offenen Schaltungsspannungswertes in Bezug auf den SoC der Batteriezelle; und
eine Tiefenladung-Berechnungseinheit (130), welche dazu eingerichtet ist, eine negative Elektrodentiefenladung der Batteriezelle auf Grundlage des inneren Widerstandswertes (30) zu berechnen.

2. Batterietiefenladung-Berechnungsvorrichtung nach Anspruch 1, wobei die Tiefenladung-Berechnungseinheit (130) ferner dazu eingerichtet ist, eine negative Elektrodentiefenladung der Batteriezelle durch ein Vergleichen des inneren Widerstandswertes (30) mit einem vorfestgelegten Wert zu berechnen.

3. Batterietiefenladung-Berechnungsvorrichtung nach Anspruch 2, wobei der vorfestgelegte Wert 2 Ohm ist.

4. Batterietiefenladung-Berechnungsvorrichtung nach Anspruch 1, wobei die Widerstand-Berechnungseinheit (120) ferner eingerichtet ist, zum:
Berechnen des Überspannungswertes in Bezug auf den SoC der Batteriezelle, welcher eine Differenz zwischen dem Spannungswert in Bezug auf den SoC der Batteriezelle und dem offenen Schaltungsspannungswert in Bezug auf den SoC der Batteriezelle ist; und
Berechnen des inneren Widerstandswertes der Batteriezelle während eines Ladens durch ein Teilen des berechneten Überspannungswertes in Bezug auf den SoC der Batteriezelle durch einen Stromwert, welcher durch die Batteriezelle fließt.

5. Batterietiefenladung-Berechnungsvorrichtung nach Anspruch 1, wobei die Widerstand-Berechnungseinheit (120) ferner dazu eingerichtet ist, den inneren Widerstandswert in Bezug auf den SoC der Batteriezelle während eines Ladens für jede C-Rate für ein Laden der Batteriezelle zu berechnen.

6. Batterietiefenladung-Berechnungsvorrichtung nach Anspruch 5, wobei die Tiefenladung-Berechnungseinheit (130) ferner dazu eingerichtet ist, eine negative Elektrodentiefenladung der Batteriezelle für jede C-Rate zu berechnen.

7. Batterietiefenladung-Berechnungsvorrichtung nach Anspruch 1, wobei eine negative Elektrodentiefenladung der Batteriezelle verwendet wird, um ein Ladeprotokoll der Batteriezelle zu erzeugen.

8. Batterietiefenladung-Berechnungsvorrichtung nach Anspruch 1, wobei die Tiefenladung ein SoC ist, in welchem eine Präzipitation von Ionen, welche in der Batteriezelle umfasst sind, stattfindet.

9. Betriebsverfahren einer Batterietiefenladung-Berechnungsvorrichtung, das Betriebsverfahren umfassend:
Erhalten (S110) eines offenen Schaltungsspannung-(OCV)-Wertes in Bezug auf einen Ladezustand (SoC) einer Batteriezelle und von Informationen über einen Spannungswert in Bezug auf einen SoC der Batteriezelle während eines Ladens;
Berechnen (S120) eines inneren Widerstandswertes (30) in Bezug auf den SoC der Batteriezelle während eines Ladens, auf Grundlage der Informationen über den Spannungswert in Bezug auf den SoC der Batteriezelle während eines Ladens und des offenen Schaltungsspannungswertes in Bezug auf den SoC der Batteriezelle; und
Berechnen (S130) einer negativen Elektrodentiefenladung der Batteriezelle auf Grundlage des inneren Widerstandswertes (30).

10. Betriebsverfahren nach Anspruch 9, wobei das Berechnen (S130) der negativen Elektrodentiefenladung der Batteriezelle auf Grundlage des inneren Widerstandswertes (30) ein Berechnen einer negativen Elektrodentiefenladung der Batteriezelle durch ein Vergleichen des inneren Widerstandswertes (30) mit einem vorfestgelegten Wert umfasst.

11. Betriebsverfahren nach Anspruch 9, wobei das Berechnen (S120) des inneren Widerstandswertes (30) in Bezug auf den SoC der Batteriezelle während eines Ladens, auf Grundlage der Informationen über den Spannungswert in Bezug auf den SoC der Batteriezelle während eines Ladens und des offenen Schaltungsspannungswertes in Bezug auf den SoC der Batteriezelle, umfasst:
Berechnen des Überspannungswertes in Bezug auf den SoC der Batteriezelle, welcher eine Differenz zwischen einem Spannungswert in Bezug auf den SoC der Batteriezelle und dem offenen Schaltungsspannungswert in Bezug auf den SoC der Batteriezelle ist; und
Berechnen des inneren Widerstandswertes (30) der Batteriezelle während eines Ladens durch ein Teilen des berechneten Überspannungswertes in Bezug auf den SoC der Batteriezelle durch einen Stromwert, welcher durch die Batteriezelle fließt.

## Revendications

1. Appareil de calcul de profondeur de charge de batterie (100) comprenant :
une unité d'obtention d'informations (110) configurée pour obtenir une valeur de tension en circuit ouvert (OCV) par rapport à un état de charge (SoC) d'un élément de batterie et des informations sur une valeur de tension par rapport à un SoC de l'élément de batterie pendant la charge ;
une unité de calcul de résistance (120) configurée pour calculer une valeur de résistance interne (30) par rapport au SoC de l'élément de batterie pendant la charge, sur la base des informations sur la valeur de tension par rapport au SoC de l'élément de batterie pendant la charge et la valeur de tension en circuit ouvert par rapport au SoC de l'élément de batterie ; et
une unité de calcul de profondeur de charge (130) configurée pour calculer une profondeur de charge d'électrode négative de l'élément de batterie sur la base de la valeur de résistance interne (30).

2. Appareil de calcul de profondeur de charge de batterie selon la revendication 1, dans lequel l'unité de calcul de profondeur de charge (130) est en outre configurée pour calculer une profondeur de charge d'électrode négative de l'élément de batterie en comparant la valeur de résistance interne (30) à une valeur prédéfinie.

3. Appareil de calcul de profondeur de charge de batterie selon la revendication 2, dans lequel la valeur prédéfinie est de 2 ohms.

4. Appareil de calcul de profondeur de charge de batterie selon la revendication 1, dans lequel l'unité de calcul de résistance (120) est en outre configurée pour :
calculer la valeur de surtension par rapport au SoC de l'élément de batterie, qui est une différence entre la valeur de tension par rapport au SoC de l'élément de batterie et la valeur de tension en circuit ouvert par rapport au SoC de l'élément de batterie ; et
calculer la valeur de résistance interne de l'élément de batterie pendant la charge en divisant la valeur calculée de surtension par rapport au SoC de l'élément de batterie par une valeur de courant circulant à travers l'élément de batterie.

5. Appareil de calcul de profondeur de charge de batterie selon la revendication 1, dans lequel l'unité de calcul de résistance (120) est en outre configurée pour calculer la valeur de résistance interne par rapport au SoC de l'élément de batterie pendant la charge pour chaque taux C pour charger l'élément de batterie.

6. Appareil de calcul de profondeur de charge de batterie selon la revendication 5, dans lequel l'unité de calcul de profondeur de charge (130) est en outre configurée pour calculer une profondeur de charge d'électrode négative de l'élément de batterie pour chaque taux C.

7. Appareil de calcul de profondeur de charge de batterie selon la revendication 1, dans lequel une profondeur de charge d'électrode négative de l'élément de batterie est utilisée pour générer un protocole de charge de l'élément de batterie.

8. Appareil de calcul de profondeur de charge de batterie selon la revendication 1, dans lequel la profondeur de charge correspond à un SoC dans lequel se produit une précipitation d'ions inclus dans l'élément de batterie.

9. Procédé de fonctionnement d'un appareil de calcul de profondeur de charge de batterie, le procédé de fonctionnement comprenant :
l'obtention (S110) d'une valeur de tension en circuit ouvert (OCV) par rapport à un état de charge (SoC) d'un élément de batterie et des informations sur une valeur de tension par rapport à un SoC de l'élément de batterie pendant la charge ;
le calcul (S120) d'une valeur de résistance interne (30) par rapport au SoC de l'élément de batterie pendant la charge, sur la base des informations sur la valeur de tension par rapport au SoC de l'élément de batterie pendant la charge et la valeur de tension en circuit ouvert par rapport au SoC de l'élément de batterie ; et
le calcul (S130) d'une profondeur de charge d'électrode négative de l'élément de batterie sur la base de la valeur de résistance interne (30).

10. Procédé de fonctionnement selon la revendication 9, dans lequel le calcul (S130) de la profondeur de charge d'électrode négative de l'élément de batterie sur la base de la valeur de résistance interne (30) comprend le calcul d'une profondeur de charge d'électrode négative de l'élément de batterie en comparant la valeur de résistance interne (30) à une valeur prédéfinie.

11. Procédé de fonctionnement selon la revendication 9, dans lequel le calcul (S120) de la valeur de résistance interne (30) par rapport au SoC de l'élément de batterie pendant la charge, sur la base des informations sur la valeur de tension par rapport au SoC de l'élément de batterie pendant la charge et la valeur de tension en circuit ouvert par rapport au SoC de l'élément de batterie comprend :
le calcul de la valeur de surtension par rapport au SoC de l'élément de batterie, qui correspond à une différence entre une valeur de tension par rapport au SoC de l'élément de batterie et la valeur de tension en circuit ouvert par rapport au SoC de l'élément de batterie ; et
le calcul de la valeur de résistance interne (30) de l'élément de batterie pendant la charge en divisant la valeur calculée de surtension par rapport au SoC de l'élément de batterie par une valeur de courant circulant à travers l'élément de batterie.
